Europäisches Patentamt

European Patent Office

Office européen des brevets

(11) Veröffentlichungsnummer: **0 315 581**
**A1**

## (12) EUROPÄISCHE PATENTANMELDUNG

(21) Anmeldenummer: 88730241.2

(22) Anmeldetag: 28.10.88

(51) Int. Cl.⁴: **H 05 K 13/00**
**H 05 K 13/02, B 65 G 15/14,**
**B 65 G 15/20**

(30) Priorität: 05.11.87 DE 3737855

(43) Veröffentlichungstag der Anmeldung:
**10.05.89 Patentblatt 89/19**

(84) Benannte Vertragsstaaten:
**AT BE CH DE ES FR GB GR IT LI NL SE**

(71) Anmelder: **Siemens Aktiengesellschaft Berlin und**
**München**
**Wittelsbacherplatz 2**
**D-8000 München 2 (DE)**

(72) Erfinder: **Proks, Gerhard, Ing. grad.**
**Usedomer Strasse 30**
**D-1000 Berlin 65 (DE)**

**Seidel, Uwe**
**Treptower Strasse 94**
**D-1000 Berlin 44 (DE)**

**Wendt, Joachim, Ing. grad.**
**Wittekindstrasse 60**
**D-1000 Berlin 42 (DE)**

(54) **Vorrichtung zum Transport flächenhafter Gegenstände.**

(57) Beim Transport flächenhafter Gegenstände durch Reibschluß mittels einer Vorrichtung mit zumindest einem Riemenpaar werden diese an einer Kante durch ein Aneinanderdrücken der das Paar bildenden Riemen gehalten. Die erforderlichen Andruckmittel wirken besonders am Anfang und am Ende der Transportstrecke.

Erfindungsgemäß ist ein federbelasteter Niederhalter (8) vorgesehen, dar einen Riemen (6) des Riemenpaares über die gesamte Transportstrecke (T) gegen den anderen Riemen (7) drückt, der seinerseits von einem Gegenhalter (17) unterstützt wird, so daß eine gleichmäßige Andruckkraft erzeugt wird. Darüber hinaus erfolgt durch die Federbelastung des Niederhalters (8) eine Anpassung an unterschiedliche Dicken der zu transportierenden flächenhaften Gegenstände.

Transport von flächenhaften Gegenständen, insbesondere von Leiterplatten oder Glassubstratplatten.

FIG.1

EP 0 315 581 A1

# Beschreibung

## Vorrichtung zum Transport flächenhafter Gegenstände

Die Erfindung bezieht sich auf eine Vorrichtung zum Transport flächenhafter Gegenstände mittels mehrerer umlaufender Riemen, die paarweise im Bereich der Transportstrecke parallel zueinander angeordnet sind und durch Andruckmittel zur Reibschlußhalterung der flächenhaften Gegenstände einander angenähert werden.

Eine derartige Transportvorrichtung ist aus der DE-OS 29 40 448 bekannt. Mit dieser Vorrichtung können kleine, mit flachen Zungen an ihren Rändern versehene Teile aufrecht stehend transportiert werden. Die zu transportierenden Teile werden dabei einseitig an ihren überstehenden Zungen von einem Riemenpaar erfaßt. Die das Riemenpaar bildenden beiden Riemen werden von zwei Klemmrollenpaaren als Andruckmittel aneinandergedrückt. Jeweils ein Klemmrollenpaar wird gebildet von zwei einander gegenüberstehenden Klemmrollen. Der Abstand der beiden Klemmrollenpaare zueinander definiert die Transportstrecke. Entlang der Transportstrecke bleiben die beiden Riemen zur Aufrechterhaltung der erforderlichen Reibschlußkraft zum Transport einander angenähert. Zusätzliche Druckmittel entlang der Strecke sind nicht vorgesehen.

Von einer derartigen bakannten Vorrichtung geht die Erfindung aus und sieht erfindungsgemäß vor, daß die Andruckmittel für ein Riemenpaar ein federbelasteter Niederhalter, der entsprechend der auf ihn wirkenden Federkraft entlang der gesamten Transportstrecke auf den einen Riemen des Riemenpaares drückt, und ein Gegenhalter sind, der den anderen Riemen im Bereich des Niederhalters unterstützt.

Wesentlicher Vorteil der erfindungsgemäßen Vorrichtung ist, daß auch größere flächenhafte Gegenstände - zumal nicht mit Zungen ausbildung an ihren Rändern - sicher über die gesamte Transportstrecke gebracht werden können. Dies wird ermöglicht durch den erfindungsgemäßen Niederhalter, der so ausgebildet ist, daß er den einen Riemen über die gesamte Transportstrecke gegen den anderen Riemen drückt bzw. die beiden Riemen einander annähert. Eine Verringerung der Andruckkraft, ggf. sogar deren Aufhebung können somit nicht eintreten. Dadurch, daß der Niederhalter mit einem Gegenhalter zusammenwirkt, der den anderen Riemen des Riemenpaares im Bereich des Niederhalters unterstützt, wird zusätzlich dafür gesorgt, daß über die gesamte Transportstrecke die für eine sichere Halterung der zu transportierenden flächenhaften Gegenstände erforderliche Reibschlußkraft aufgebracht ist. Darüber hinaus können mit der erfindungsgemäßen Vorrichtung flächenhafte Gegenstände mit einem relativ breiten Dickenspektrum transportiert werden, da der Niederhalter federbelastet ist und so gewährleistet ist, daß die flächenhaften Gegenstände stets zwischen den Riemen eines Riemenpaares aufgenommen werden können. Hiermit wird gleichzeitig die Wirkung erzielt, daß die Andruckkraft durch den Niederhalter immer stärker wird, je dicker die zu transportierenden flächenhaften Gegenstände sind.

Nach einer Ausgestaltung der erfindungsgemäßen Vorrichtung kann, wie aus der DE-OS 29 40 448 bekannt, ein einziges Riemenpaar vorgesehen sein, welches entsprechend eine Kante der zu transportierenden flächenhaften Gegenstände erfaßt. Dabei kann das Riemenpaar bei der erfindungsgemäßen Vorrichtung auch so orientiert sein, daß die flächenhaften Gegenstände waagerecht, also liegend transportiert werden. Dies wird ermöglicht durch die starke, über die gesamte Transportstrecke konstant aufgebrachte Reibschlußkraft, die ein Abkippen oder Schaukeln der zu transportierenden flächenhaften Gegenstände verhindert. Bei einem waagerechten Transport der Gegenstände ist eine weitere Bearbeitung, z. B. Vorpositionieren einzelner Bauteile ohne deren endgültige Befestigung, damit wesentlich erleichtert.

Nach einer anderen Ausgestaltung der erfindungsgemäßen Vorrichtung sind zwei Riemenpaare in einer solchen Anordnung vorgesehen, daß sie die zu transportierenden flächenhaften Gegenstände an zwei parallelen Längskanten erfassen. Hierbei ist eine horizontale oder vertikale Orientierung der beiden Riemenpaare zueinander und damit der zu transportierenden flächenhaften Gegenstände möglich. Die Ausrichtung kann in Abhängigkeit von erforderlichen Bearbeitungsvorgängen, Lagerungen o. ä. der flächenhaften Gegenstände gewählt werden. Der Vorteil einer derartigen Ausgestaltung ist, daß flächenhafte Gegenstände nahezu beliebiger Größe und damit auch entsprechenden Gewichts sicher transportiert werden können. Durch die beidseitige Lagerung kann die mechanische Belastung der flächenhaften Gegenstände verringert werden, so daß auch empfindliche Gegenstände, wie z. B. dünnwandige Glasubstratplatten, sicher transportiert werden können.

Gemäß einer anderen Ausgestaltung der erfindungsgemäßen Vorrichtung können beide Riemen eines Riemenpaares identische Zahnriemen sein. Der Vorteil solcher, an sich bekannter Zahnriemen liegt in der sicheren Übertragung der Antriebskraft und in den guten Führungseigenschaften der Riemen. Bei identischer Ausführung der Riemen mit ebener Oberfläche können mit der erfindungsgemäßen Vorrichtung flächenhafte Gegenstände mit einer Dicke von ca. 3 mm bis ca. 1,5 mm sicher transportiert werden.

Nach einer weiteren Ausgestaltung der erfindungsgemäßen Vorrichtung ist vorgesehen, daß beide Riemen eines Riemenpaares Zahnriemen sind und zumindest der eine Riemen Zusätzlich auf seiner Oberseite entlang einer Kante einen schmalen Reibbelag trägt. Bei einer derartigen Ausgestaltung ist günstigerweise der untere Riemen eines Riemenpaares derjenige ohne zusätzlichen Reibbelag, so daß seine Oberseite sozusagen ein "Nullniveau" für eine Seite der zu transportierenden flächenhaften Gegenstände bildet. Ein solches Nullniveau ist deshalb sinnvoll, weil mit ihm beispielsweise die Übergabehöhe der flächenhaften Gegenstände an beliebige Bearbeitungsstationen einfach festlegbar ist. Entsprechend trägt dann der obere Riemen den zusätzlichen Reibbelag (solche Riemen sind an sich bekannt, z. B. Breco-Zahnriemen 10T5/960 der Firma Mulco). Neben einer möglichen Erhöhung der Reibschlußkraft bei Verwendung eines solchen Riemens ist wesentlich von Vorteil, daß flächenhafte Gegenstände mit Dicken bis zu 0,5 mm sicher transportiert werden können.

Bei Anwendung solcher Zahnriemen können diese gemäß einer anderen Ausgestaltung der erfindungsgemäßen Vorrichtung auf ihrer Unterseite zwei zueinander beabstandete Zahnreihen aufweisen und in den zwischen den Zahnreihen vorhandenen Abstand der Niederhalter und der Gegenhalter eingreifen. Durch einen derartigen Riemenaufbau können zum einen die Riemen gut auf den Riemenscheiben geführt werden, zum anderen ist für eine gute Führung zum Niederhalter und zum Gegenhalter gesorgt, so daß die Riemen immer parallel einander gegenüberliegen und nicht ggf. seitwärts ausweichen können. Zum Transport von flächenhaften Gegenständen mit einem vergleichsweise schmalen freien Randbereich ist ein derartiger Riemenaufbau vorteilhaft, weil der Randbereich des Riemenpaares wegen der Führung durch Niederhalter und Gegenhalter die Federkraft mittelbar sicher überträgt und damit den Reibschluß sichert.

Gemäß einer anderen Ausgestaltung der erfindungsgemäßen Vorrichtung kann zwischen die Riemen eines Riemenpaares ein ortsfester Kantenanschlag für die zu transportierenden flächenhaften Gegenstände hineinragen. Ein solcher Anschlag gewährleistet eine gute Seitenführung der zu transportierenden flächenhaften Gegenstände. Sind diese jedoch besonders dünn, so kann durch den zusätzlichen Reibbelag auf der Oberseite zumindest eines der Riemen ein sicherer Transport ohne Bremskraft durch den Kantenanschlag bewirkt werden.

Mit der erfindungsgemäßen Vorrichtung können unterschiedliche flächenhafte Gegenstände - z. B. dicke Stahlplatten, mitteldicke Leiterplatten oder dünne Glassustratplatten - transportiert werden. Die erfindungsgemäße Transportvorrichtung erlaubt eine zwangsweise Be- und Entladung der Transportstrecke benachbarten Bearbeitungsplätzen.

Anhand dreier Figuren wird im folgenden der Aufbau und die Funktionsweise der erfindungsgemäßen Vorrichtung in bevorzugten Ausführungsformen näher erläutert. Es zeigen dabei die

Figur 1 eine schematische, teilweise geschnittene Ansicht eines Ausführungsbeispiels der erfindungsgemäßen Vorrichtung längs der Transportstrecke, die

Figur 2 einen Schnitt durch die Vorrichtung gemäß Figur 1 an der gekennzeichneten Stelle AB in vergrößertem Maßstab und die

Figur 3 den Querschnitt eines Zahnriemens in vergrößertem Maßstab, wie er in der erfindungsgemäßen Vorrichtung verwendet werden kann, in den Figuren 1 bzw. 2 jedoch nicht dargestellt ist.

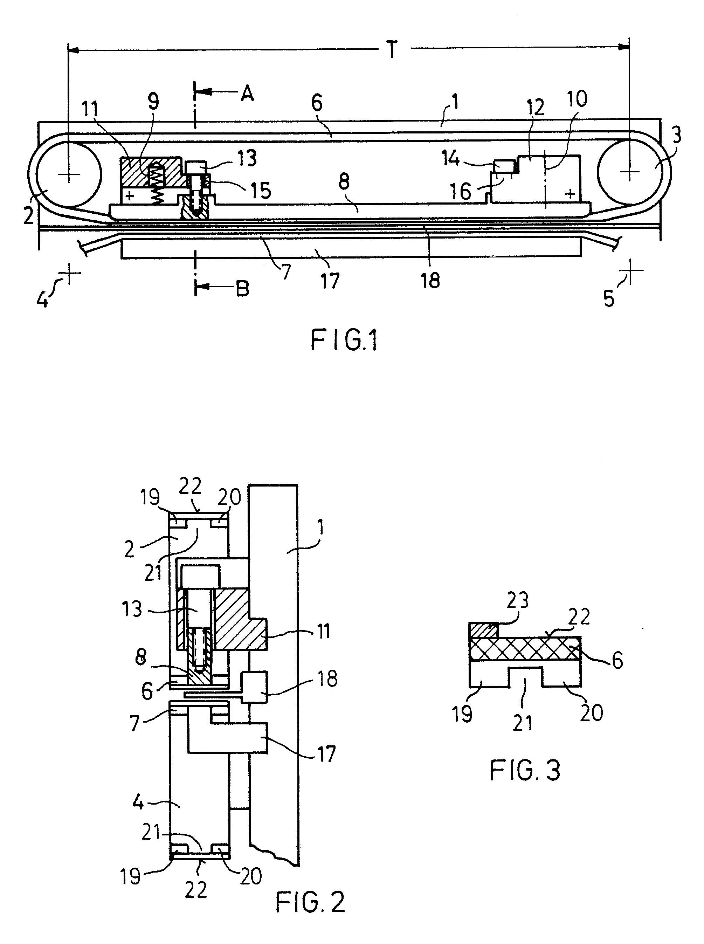

Figur 1 zeigt eine Vorrichtung zum Transport flächenhafter Gegenstände mit zwei einander parallel zugeordneten Riemenpaaren, von denen zum besseren Verständnis nur eines dargestellt ist. An einem Träger 1 sind zwei Riemenscheibenpaare 2, 3 und 4, 5 befestigt. Von dem zweiten Riemenscheibenpaar 4, 5 sind der Übersichtlichkeit halber nur die Mittelpunkte angedeutet. Um die Riemenscheiben 2 und 3 ist ein erster Riemen 6 gelegt, der beispielsweise ein Zahnriemen sein kann. Mit ihm wirkt ein anderer Riemen 7, der auch ein Zahnriemen sein kann und um die Riemenscheiben 4 und 5 gelegt ist, zusammen.

Der Abstand der Riemenscheiben 2 und 3 zueinander bildet eine Transportstrecke T, die relativ beliebig in ihrer Länge gewählt sein kann. Zwischen den beiden Riemenscheiben 2 und 3 ist ein Niederhalter 8 angeordnet, der mittels Federn 9 und 10 sowie Halteblöcken 11 und 12 an dem Träger 1 gelagert ist. Hierzu sind Schrauben 13 und 14 in den Niederhalter 8 eingeschraubt und in jeweils einer Durchgangsbohrung 15 und 16 in den Halteblöcken 11 und 12 geführt. Durch die Federn 9 und 10 wird der Niederhalter 8 auf den ersten Riemen 6 gedrückt, so daß dieser dem anderen Riemen 7 angenähert wird. Der andere Riemen 7 liegt im Bereich des Niederhalters 8 auf einem Gegenhalter 17 auf. Zwischen den beiden Riemen 6 und 7 ist in der Figur 1 noch ein Kantenanschlag 18 angedeutet, der für eine seitliche Führung der zu transportierenden flächenhaften Gegenstände sorgt.

Aus Figur 2 ist ersichtlich, daß beide Riemen 6 und 7 identische Zahnriemen mit innenliegenden Zähnen sind. Jeder Riemen 6, 7 weist zwei Zahnreihen 19, 20 auf, die einen Abstand 21 zueinander haben. Auf ihrer Oberseite 22 sind beide Riemen 6, 7 eben. In dem Abstand 21 greifen die Riemenscheiben 2 und 4 sowie der Niederhalter 8 und der Gegenhalter 17 ein, so daß eine gute Seitenführung der Riemen 6 und 7 gegeben ist.

Zwischen die Riemen 6 und 7 ragt der Kantenanschlag 18, der fest mit dem Träger 1 verbunden ist. Der Kantenanschlag 18 bewirkt eine verkantungsfreie Schienenführung im Kantenbereich der Riemen 6 und 7. Bei deisem Ausführungsbeispiel ist ein Transport sicher gewährleistet, wenn der Kantenanschlag 18 in seiner Dicke geringer bemessen ist als die Dicke der zu transportierenden flächenhaften Gegenstände. Zur Aufrechterhaltung der Schienenführung ist jedoch eine Mindestdicke vorzusehen, die an sich eine Mindestdicke der zu transportierenden Gegenstände bedingt. Um jedoch auch sehr dünne Gegenstände, wie z. B. Glassubstratplatten, mit der erfindungsgemäßen Vorrichtung transportieren zu können, kann -wie die Figur 3 zeigt - ein zusätzlicher Reibbelag 23 vorgesehen sein, der auf der Oberseite 22 des Riemens 6 angeordnet ist. Damit können nicht nur hohe Reibschlußkräfte übertragen werden, sondern auch flächenhafte Gegenstände transportiert werden, deren Dicke etwas größer ist als die Differenz zwischen der Dicke des Kantenanschlages 18 und der Dicke des Reibbelages 23 entspricht. Für einen Transport von Folien ist es auch möglich, den unteren Riemen 7 aus Figur 2 ebenfalls mit einem zusätzlichen Reibbelag 23 zu versehen.

**Patentansprüche**

1. Vorrichtung zum Transport flächenhafter Gegenstände mittels mehrerer umlaufender Riemen, die paarweise im Bereich der Transportstrecke parallel zueinander angeordnet sind un durch Andruckmittel zur Reibschlußhalterung der flächenhaften Gegenstände einander angenähert werden,
**dadurch gekennzeichnet,** daß die Andruckmittel für ein Riemenpaar ein federbelasteter Niederhalter (8), der entsprechend der auf ihn wirkenden Federkraft entlang der gesamten Transportstrecke (T) auf den einen Riemen (6) des Riemenpaares drückt, und ein Gegenhalter (17) sind, der den anderen Riemen (7) im Bereich des Niederhalters (8) unterstützt. (Fig. 1, 2)

2. Vorrichtung nach Anspruch 1, **dadurch gekennzeichnet,** daß ein einziges Riemenpaar vorgesehen ist, welches eine Kante des zu transportierenden flächenhaften Gegenstandes erfaßt.

3. Vorrichtung nach Anspruch 1, **dadurch gekennzeichnet,** daß zwei Riemenpaare in einer solchen Anordnung vorgesehen sind, daß sie die zu transportierenden flächenhaften Gegenstände an zwei parallelen Längskanten erfassen.

4. Vorrichtung nach einem der vorangegangenen Ansprüche, **dadurch gekennzeichnet,** daß beide Riemen (6, 7) eines Riemenpaares identische Zahnriemen sind. (Fig. 1, 2)

5. Vorrichtung nach einem der Ansprüche 1 bis 3, **dadurch gekennzeichnet,** daß beide Riemen (6, 7) eines Riemenpaares Zahnriemen sind und zumindest der eine Riemen (6) zusätzlich auf seiner Oberseite (22) entlang einer Kante einen schmalen Reibbelag (23) trägt. (Fig.3)

6. Vorrichtung nach einem der Ansprüche 4 oder 5, **dadurch gekennzeichnet,** daß die Riemen (6, 7) auf ihrer Unterseite zwei zueinander beabstandete Zahnreihen (19, 20) aufweisen und in den zwischen den Zahnreihen (19, 20) vorhandenen Abstand (21) der Niederhalter (8) und der Gegenhalter (17) eingreifen. (Fig. 1, 2)

7. Vorrichtung nach einem der vorangehenden Ansprüche, **dadurch gekennzeichnet,** daß zwischen die Riemen (6, 7) eines Riemenpaares ein ortsfester Kantenanschlag (18) für die zu transportierenden flächenhaften Gegenstände hineinragt. (Fig. 1, 2)

87 P 4118

FIG.1

FIG.2

FIG. 3

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | EP-A-0234125 (GPD CANADA)<br>* Spalte 3, Zeile 18 - Zeile 46; Figuren 1-4 *<br>--- | 1,2,4 | H05K13/00<br>H05K13/02<br>B65G15/14<br>B65G15/20 |
| X | US-A-3468409 (PHILLIPS PETROLEUM)<br>* Spalte 2, Zeile 71 *<br>* Spalte 3, Zeile 1 - Zeile 25 *<br>* Spalte 3, Zeile 45 - Zeile 48; Figuren 1-4 *<br>--- | 1 | |
| A | US-A-3021610 (WINKLER)<br>* Spalte 3, Zeile 63 - Zeile 72; Figuren 1, 2 *<br>--- | 1 | |
| A | FR-A-2267263 (DUBUIT)<br>* Seite 8, Zeile 35 - Zeile 40; Figuren 1, 2 *<br>--- | 1,3 | |
| A,D | FR-A-2438605 (CIT-ALCATEL)<br>* Seite 3, Zeile 2 - Zeile 7; Figuren 1-4 *<br>----- | 1,2 | |

|  |
|---|
| RECHERCHIERTE SACHGEBIETE (Int. Cl.4) |
| H05K<br>B65G |

Der vorliegende Recherchenbericht wurde für alle Patentansprüche erstellt

| Recherchenort | Abschlußdatum der Recherche | Prüfer |
|---|---|---|
| DEN HAAG | 13 JANUAR 1989 | LOMMEL A. |

EPO FORM 1503 03.82 (P0403)